# EUROPÄISCHE PATENTANMELDUNG

(11) **EP 1 870 190 A1**
(43) Veröffentlichungstag der Anmeldung: **26.12.2007**
(21) Anmeldenummer: 06021441.8
(22) Anmeldetag: 12.10.2006
(51) Int. Cl.: B23K 1/00, B23K 1/015, B23K 1/20, H05K 3/28, H05K 3/34, H05K 7/20, B23K 101/42

(54) **Dampfphasen-Löten von elektronischen Bauelementen mit einer Überhitzungsschutzschicht; Bauelemente mit einer Überhitzungsschutzschicht**

(30) Priorität: 22.06.2006 DE 102006028653
(71) Anmelder: Linde Aktiengesellschaft, 65189 Wiesbaden (DE)
(72) Erfinder: Wandke, Ernst, Dr., 82538 Geretsried (DE)

(57) **Zusammenfassung**

Die Erfindung bezieht sich auf ein Verfahren zum Dampfphasenlöten elektronischer Bauelemente (1). Dabei werden vor dem Einbringen der zu verlötenden Bauelemente (1), diese mit einer dampfabweisenden Schutzschicht versehen, so dass sie gegen eine Überhitzung geschützt sind. Weiter bezieht sich die Erfindung auch auf ein elektronisches Bauelement (1) mit einer dampfabweisenden Schutzschicht zum Schutz vor Überhitzung beim Dampfphasenlöten und auf eine entsprechende Verwendung.

## Beschreibung

Die vorliegende Erfindung bezieht sich auf ein Verfahren zum Vapour-Phase-Löten (Dampfphasenlöten) eines elektronischen Bauelementes, auf ein elektronisches Bauelement für dieses Verfahren und auf eine Verwendung eines solchen Bauelements in dem erfindungsgemäßen Verfahren zum Dampfphasenlöten.

Bei dem an sich bekannten Dampfphasenlöten wird beispielsweise eine mit elektronischen Bauelementen vormontierte und auch mit einem Lot versehen Leiterplatte in einen Dampf eingebracht. Dabei liegt die Leiterplattentemperatur wesentlich unterhalb der Kondensationstemperatur des Dampfes. Der Dampf kondensiert an den Oberflächen und erhitzt über die dabei freigesetzte Kondensationswärme das eingebrachte Material. Das Lot schmilzt und die elektronischen Bauelemente werden mit der Leiterplatte verlötet. Der Dampf kann beispielsweise ein Perfluorpolyetherdampf sein.

Der vorliegenden Erfindung liegt das technische Problem zugrunde, ein verbessertes Verfahren zum Verlöten von elektronischen Bauelementen in einem Dampf anzugeben.

Die Erfindung bezieht sich auf ein Verfahren zum Dampfphasenlöten eines elektronischen Bauelementes in einem Dampf mit den Schritten: Einbringen eines mit dem elektronischen Bauelement und mit einem Lot versehenen Trägers in den Dampf, so dass der Dampf zum Verlöten kondensiert, gekennzeichnet durch einen, vor dem Einbringen des Trägers in den Dampf durchzuführenden, weiteren Schritt: Aufbringen einer dampfabweisenden Schutzschicht auf einen Anteil der Oberfläche des elektronischen Bauelementes zum Schutz vor Überhitzung.

Bevorzugte Ausgestaltungen der Erfindung sind in den abhängigen Ansprüchen angegeben und werden im Folgenden näher erläutert.

Die Erfindung geht von der Tatsache aus, dass ein hoher Wärmeeintrag zu einer Schädigung von elektronischen Bauelementen beim Verlöten führen kann. Dies kann insbesondere bei elektronischen Bauelementen mit einer großen Oberfläche der Fall sein, da diesen über die große Oberfläche auch viel Wärme zugeführt werden kann.

Außerdem kann es wünschenswert sein, bleifreie Lote zu verwenden, obwohl sie zu einer im Vergleich zu bleihaltigem Lot erhöhten Löttemperatur und damit zu einem erhöhten Wärmeeintrag führen. Beispielsweise wird bleifreies Lot verwendet, wenn gesetzlichen Bestimmungen genügt werden oder das Produkt besonders umweltfreundlich hergestellt werden soll. Die Gefahr, die elektronischen Bauelemente zu schädigen, ist dann entsprechend größer.

Die Erfindung basiert auf der Erkenntnis, dass beim Dampfphasenlöten ein Wärmeeintrag hauptsächlich über die Kondensationswärme erfolgt und ein Reduzieren des Kondensationswärmeeintrages auf einen Teil der Oberflächen eines elektronischen Bauelementes zu einem reduzierten Wärmeeintrag und damit zu einem schonenderen Verlöten des elektronischen Bauelementes führt. Dazu wird eine dampfabweisende Schutzschicht auf einen Anteil der Oberfläche des elektronischen Bauelementes aufgebracht. Wird die Kondensation des Dampfes an dieser Oberfläche verhindert oder zumindest reduziert, so erfährt das elektronische Bauelement einen entsprechend reduzierten Wärmeeintrag. Dabei kann ggf. nur der Teil der Oberfläche des elektronischen Bauelementes mit einer Schutzschicht überzogen werden, welcher sich nicht in direkter Umgebung der geplanten Lötstelle befindet. So kann das elektronische Bauelement geschützt und kann gleichzeitig die Lötstelle auch effizient verlötet werden.

Üblicherweise wird ein Träger, etwa eine Leiterplatte, mit mehr als einem elektronischen Bauelement verlötet. Im Folgenden stehen die elektronischen Bauelemente daher im Plural; der Fall eines einzelnen Bauelementes soll jedoch mit umfasst sein.

Oft weisen elektronische Bauelemente einen Sockel zum Verlöten mit dem Träger auf. Vorzugsweise wird auf einen solchen Sockel keine dampfabweisende Schutzschicht aufgebracht, sondern lediglich auf andere Teile der Oberfläche der elektronischen Bauelemente. So kann ein ungehinderter Eintrag der Kondensationswärme in die Lötstellen erfolgen und trotzdem können die elektronischen Bauelemente vor einem übermäßigen Wärmeeintrag geschützt werden.

Damit die Sockel der elektronischen Bauelemente nicht mit einer dampfabweisenden Schutzschicht versehen werden, können diese abgedeckt werden. Eine entsprechende Abdeckung kann beispielsweise ein Träger sein, in dem die elektronischen Bauelemente so eingefasst sind, dass die Sockel komplett in den Träger eingebracht sind und die zu beschichtenden Oberflächen der elektronischen Bauelemente aus dem Träger herausragen.

Vorzugsweise werden die elektronischen Bauelemente zum Aufbringen der Schutzschicht in ein Tauchbad getaucht. Das Tauchbad enthält den Stoff, welcher nach dem Eintauchen der elektronischen Bauelemente auf diesen die Schutzschicht ausbildet. Das Tauchen von elektronischen Bauelementen ist produktionstechnisch besonders einfach, da lediglich ein Tauchbad mit einer entsprechenden Füllung und eine Möglichkeit zum Eintauchen der elektronischen Bauelemente benötigt wird. Die elektronischen Bauelemente können auf einen Träger, welcher mit dem zu verlötenden Träger identisch sein kann, montiert und so gleichzeitig in großer Stückzahl parallel eingetaucht werden.

Bei einer bevorzugten Ausführungsform der Erfindung durchlaufen die elektronischen Bauelemente nach dem Tauchen eine Abtropfstrecke. So kann verhindert werden, dass nicht unnötig viel des Tauchbadinhaltes verschleppt wird. Je nach Zusammensetzung der Schutzschicht ist es auch möglich, dass ein Aushärten der Schutzschicht gewünscht ist.

Vorzugsweise enthält das Tauchbad Hexamethyldisiloxan.

Bei einer alternativen bevorzugten Ausführungsform werden die elektronischen Bauelemente zunächst in eine Niederdruckplasmakammer eingebracht. Dazu können die elektronischen Bauelemente auf einen Träger, welcher mit dem zu verlötenden Träger identisch sein kann, montiert sein. Nach dem Chargieren wird der Druck in der Niederdruckplasmakammer auf etwa 0,2 mbar abgesenkt, um dann anschließend auf einen Druck zwischen 0,5 und 0,8 mbar geflutet zu werden.

In dem anschließenden Plasmaprozess (in der Regel mit einem HF- oder Mikrowellenplasma) wird die Oberfläche der elektronischen Bauelemente weiter gereinigt, zusätzlich aber auch aktiviert und so für eine Beschichtung vorbereitet.

Es hat sich bewährt, während der Plasmabehandlung den Druck in der Niederdruckplasmakammer auf einen Wert zwischen 0,2 mbar und 0,8 mbar einzustellen. Es hat sich gezeigt, dass das Plasma in diesem Druckbereich besonders wirksam ist.

Reaktanden für die Schutzschichtbildung können etwa zusammen mit einem Trägergas, beispielsweise Argon, in die Niederdruckplasmakammer eingebracht werden. Bei einer bevorzugten Ausführungsform der Erfindung ist einer der Reaktanden ein Monomer. Mit Hilfe der Plasmaentladung kann sich dann eine ein Polymer aufweisende Schutzschicht ausbilden (Plasmapolymerisationsprozess). Unter einem Monomer wird hier ein niedermolekulares Molekül verstanden, welches sich zu Polymeren zusammenschließen kann.

Es ist bevorzugt, fluorierte Kohlenwasserstoffe, etwa C₂F₆ und/oder CF₄, als Reaktand zusammen mit einem Trägergas in die Niederdruckplasmakammer einzubringen. Unterstützt durch die Plasmapolymerisation kann so eine dampfabweisende Schutzschicht aus einer Fluor aufweisenden Kohlenstoffverbindung, etwa Polytetrafluorethylen, entstehen.

Vorzugsweise beträgt der Druck in der Niederdruckplasmakammer während der Bildung der Schutzschicht 0,2 mbar bis 1,0 mbar, bevorzugter ist ein Wert zwischen 0,2 mbar und 0,8 mbar, noch bevorzugter ist ein Wert zwischen 0,4 mbar und 0,8 mbar. Damit lassen sich eine gute Plasmawirkung und eine gute Verteilung erreichen.

Vorzugsweise wird in der Niederdruckplasmakammer auf den elektronischen Bauelementen eine Schutzschicht mit einer Dicke zwischen 5 und 100 nm gebildet. Ist die Schutzschicht wesentlich dünner, so schützt sie evtl. nicht so effektiv vor dem Wärmeeintrag. Für dickere Schutzschichten muss man die Schutzschichtbildung entsprechend länger fortsetzen, so dass ein verbesserter Schutz durch eine dickere Schutzschicht nicht mehr im Verhältnis zu der zusätzlich aufgewandten Zeit steht. Bevorzugter ist eine Schutzschichtdicke zwischen 20 und 40 nm.

Alternativ zum Eintauchen der elektronischen Bauelemente in ein Tauchbad und zum Aufbringen einer Schutzschicht unter Zuhilfenahme einer Plasmaentladung ist es möglich, eine die Schutzschicht bildende Flüssigkeit strömend an einem elektronischen Bauelement vorbeizuführen (Fluten). Dazu können die elektronischen Bauelemente etwa auf eine abschüssige Unterlage gelegt werden, so dass die Flüssigkeit von dem oberen Teil der Unterlage zu deren unteren Teil fließt, dabei an den elektronischen Bauelementen vorbeiströmt und diese benetzen kann. Alternativ können die elektronischen Bauelemente etwa auch auf eine durchlöcherte Rüttelplatte gelegt werden und von oben durch eine Düse mit der Flüssigkeit begossen werden. Durch das Rütteln kann gewährleitstet werden, dass die Flüssigkeit sämtliche Seiten der elektronischen Bauelemente im Vorbeiströmen erreichen kann. Durch die Löcher der Rüttelplatte kann die überschüssige Flüssigkeit abfließen. Das Wort "Strömen" umfasst in diesem Zusammenhang einen im Wesentlichen in sich geschlossenen Fluss bzw. Strahl. Alternativ kann man die Flüssigkeit auf die elektronischen Bauelemente aufsprühen. Gegebenenfalls können bestimmte Teile der Oberfläche der elektronischen Bauelemente zuvor abgedeckt werden.

Vorzugsweise weist die Schutzschicht Silikonkautschuk oder ein silikonkautschukähnliches Material auf. Bei einer anderen bevorzugten Ausführungsform der Erfindung weist die Schutzschicht Polytetrafluorethylen oder ein polytetrafluorethylenähnliches Material auf.

Die Erfindung bezieht sich auch auf ein elektronisches Bauelement mit einer dampfabweisenden Schutzschicht auf einem Anteil seiner Oberfläche. Diese Schutzschicht schützt vor Überhitzungen beim Dampfphasenlöten nach einem der oben beschriebenen Dampfphasenlötverfahren.

Weiter bezieht sich die Erfindung auch auf die Verwendung eines wie eben beschriebenen elektronischen Bauelements für ein erfindungsgemäßes Verfahren zum Dampfphasenlöten.

Im Folgenden soll die Erfindung anhand von Ausführungsbeispielen näher erläutert werden. Die dabei offenbarten Einzelmerkmale können auch in anderen Kombinationen erfindungswesentlich sein.
- Figur 1: zeigt eine Tauchvorrichtung zum erfindungsgemäßen Aufbringen einer Schutzschicht für das erste Ausführungsbeispiel.
- Figur 2: zeigt eine Plasmabeschichtungsvorrichtung zum erfindungsgemäßen Aufbringen einer Schutzschicht für das zweite Ausführungsbeispiel.

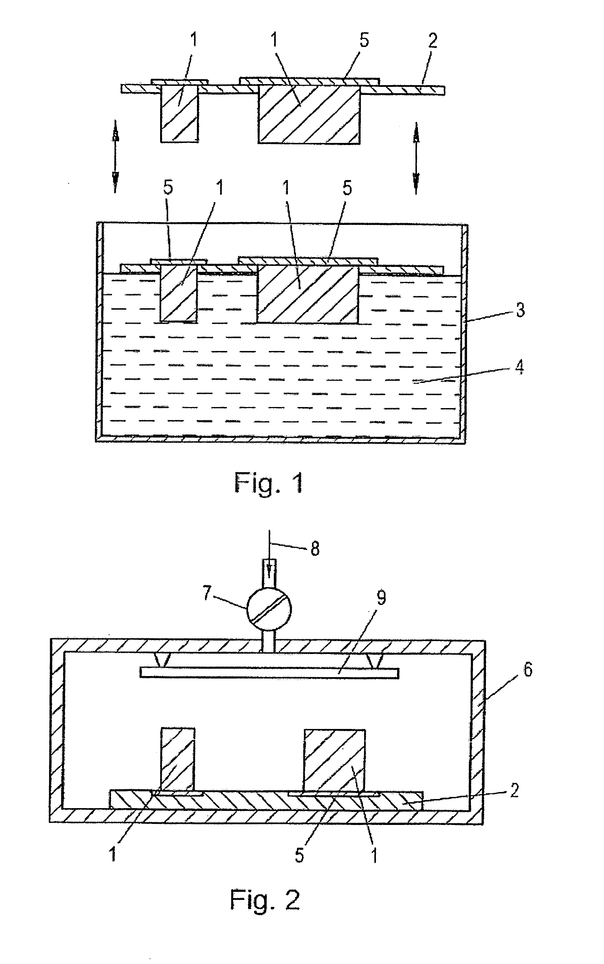

Figur 1 zeigt für das erste Ausführungsbeispiel ein Tauchbad 3, gefüllt mit flüssigem Hexamethyldisiloxan 4. Elektrolytkondensatoren 1 sind an einem steifen Bauelementträger 2 fixiert. Die Elektrolytkondensatoren 1 weisen jeweils einen Sockel 5 auf, wobei die Sockel 5 der Elektrolytkondensatoren 1 dem Tauchbad 3 abgewandt sind.

Der Bauelementträger 2 kann auf und ab bewegt werden, so dass die Elektrolytkondensatoren 1 in das Hexamethyldisiloxan 4 des Tauchbades 3 getaucht werden können. Dabei wird der Bauelementträger 2 lediglich so weit auf das Hexamethyldisiloxan 4 zubewegt, dass der Bauelementträger 2 selber und entsprechend auch die Sockel 5 der Elektrolytkondensatoren 1 nicht in das Hexamethyldisiloxan 4 eingetaucht werden. Im Anschluss an das Tauchen wird der Träger 2 wieder aus dem Hexamethyldisiloxan 4 herausgezogen und über eine Abtropfstrecke (nicht gezeigt) geführt. Überschüssiges Hexamethyldisiloxan 4 kann hier abtropfen und die sich ausbildende Schicht auf der Oberfläche der Elektrolytkondensatoren 1 aushärten. Das Aushärten kann unter dem Einfluss einer UV- oder Infrarotbeleuchtung durchgeführt werden.

Anschließend werden die Elektrolytkondensatoren 1 aus ihrer Fixierung in dem Bauelementträger 2 gelöst und in bekannter Weise auf einer mit einem Lot versehenen Leiterplatte montiert (nicht gezeigt). Diese wird dann zusammen mit den Elektrolytkondensatoren 1 und ggf. anderen elektronischen Bauelementen in einer bekannten Dampfphasenlötanlage in einen Dampf aus Perfluorpolyether eingebracht (nicht gezeigt). Der Dampf kondensiert an den wesentlich kälteren Oberflächen, so dass die Kondensationswärme das Lot aufschmilzt und die elektronischen Bauelemente mit der Leiterplatte verlötet werden. Bei einer Lötzeit von 1,5 min nehmen hier die mit der Schutzschicht versehenen Elektrolytkondensatoren 1 lediglich 30 % der Wärme auf, die sie aufnehmen würden, wenn sie unbeschichtet geblieben wären.

Figur 2 zeigt für das zweite Ausführungsbeispiel eine Niederdruckplasmakammer 6. Elektrolytkondensatoren 1 sind auch hier auf einem steifen Bauelementträger 2 fixiert, wobei die Sockel 5 der Elektrolytkondensatoren 1 in den Bauelementträger 2 eingebracht sind. Der Bauelementträger 2 befindet sich innerhalb der Niederdruckplasmakammer 6 und die Elektrolytkondensatoren 1 weisen dabei nach oben. An der oberen Innenseite der Kammer 6 erkennt man eine Antenne zur Einkopplung der Erregerfrequenz 9. Darüber befindet sich ein Ventil 7, durch welches ein Prozessgas 8 (gegebenenfalls kann je nach Betriebsphase ein anderes Prozessgas 8 verwendet werden) in die Kammer 6 eingebracht werden kann.

Die Niederdruckplasmakammer 6 wird zunächst evakuiert, bis ein Enddruck von 0,2 mbar erreicht ist. Anschließend wird die Niederdruckplasmakammer 6 mit Argon bis zu einem Druck von 0,5 mbar geflutet.

Anschließend wird über die Antenne 9 eine Plasmaentladung unterhalten, welche die Oberflächen der Elektrolytkondensatoren 1 säubert und aktiviert. Bei laufender Plasmaentladung wird dann über das Ventil 7 ein Prozessgas 8 aus Argon als Trägergas mit C₂F₆ als Reaktand in die Niederdruckplasmakammer 6 eingeführt. Dabei wird dieses Prozessgas 8 laufend erneuert, etwa mit 1,2 m³/h, so dass sich ein Enddruck von 0,5 mbar einstellt.

Auf der Oberfläche der Elektrolytkondensatoren 1 bildet sich durch Plasmapolymerisation eine dampfabweisende sowie haft- und abriebfeste teflonähnliche Schicht aus, und zwar etwa 30 nm in 3 min. Ist die gewünschte Schichtdicke von 30 nm erreicht, wird die Kammer gespült und geflutet und anschließend der Bauelementträger 2 zusammen mit den Elektrolytkondensatoren 1 aus der Niederdruckplasmakammer 6 ausgeschleust; zum Verlöten der Elektrolytkondensatoren 1 kann dann wie oben beschrieben verfahren werden.

### Bezugszeichenliste

- 1: Elektrolytkondensatoren
- 2: Bauelementträger
- 3: Tauchbad
- 4: Hexamethyldisiloxan
- 5: Sockel
- 6: Niederdruckplasmakammer
- 7: Ventil
- 8: Prozessgas
- 9: Antenne

## Patentansprüche

1. Verfahren zum Dampfphasenlöten eines elektronischen Bauelementes (1) in einem Dampf mit den Schritten:
Einbringen eines mit dem elektronischen Bauelement (1) und mit einem Lot versehenen Trägers in den Dampf, so dass der Dampf zum Verlöten kondensiert,
**gekennzeichnet durch** einen, vor dem Einbringen des Trägers in den Dampf durchzuführenden, weiteren Schritt:
Aufbringen einer dampfabweisenden Schutzschicht auf einen Anteil der Oberfläche des elektronischen Bauelementes (1) zum Schutz vor Überhitzung.

2. Verfahren nach Anspruch 1, bei dem das elektronische Bauelement (1) einen Sockel (5) aufweist und dieser von der Schutzschicht frei bleibt.

3. Verfahren nach einem der vorangehenden Ansprüche, bei dem das elektronische Bauelement zum Aufbringen der Schutzschicht in ein Tauchbad (3) getaucht wird.

4. Verfahren nach Anspruch 3, bei dem das elektronische Bauelement (1) nach dem Tauchen eine Abtropfstrecke durchläuft.

5. Verfahren nach Anspruch 3 oder 4, bei dem das Tauchbad (3) Hexamethyldisiloxan (4) enthält.

6. Verfahren nach Anspruch 1 oder 2 mit den weiteren Schritten:
Einbringen des elektronischen Bauelementes (1) in eine Niederdruckplasmakammer (6),
Behandeln des Anteils der Oberfläche des elektronischen Bauelementes (1) mit einem Plasma und
Plasmaabscheidung der Schutzschicht in der Niederdruckplasmakammer (6).

7. Verfahren nach Anspruch 6, bei dem während der Plasmabehandlung ein Druck von 0,2 bis 0,8 mbar in der Niederdruckplasmakammer (6) herrscht.

8. Verfahren nach Anspruch 6 oder 7, bei dem zur Schutzschichtbildung ein Monomer in die Niederdruckplasmakammer eingebracht wird.

9. Verfahren nach Anspruch 8, bei dem ein fluorierter Kohlenwasserstoff zur Schutzschichtbildung in die Niederdruckplasmakammer eingebracht wird.

10. Verfahren nach einem der Ansprüche 6 bis 9, bei dem der Gesamtdruck während der Bildung der Schutzschicht auf dem elektronischen Bauelement (1) 0,2 bis 1,0 mbar beträgt.

11. Verfahren nach einem der Ansprüche 6 bis 10, bei dem die auf dem Anteil der Oberfläche abgeschiedene Schutzschicht zwischen 5 und 100 nm dick ist.

12. Verfahren nach einem der vorangehenden Ansprüche, bei dem die Schutzschicht ein silikonkautschukähnliches Material aufweist.

13. Verfahren nach einem der vorangehenden Ansprüche, bei dem die Schutzschicht ein polytetrafluorethylenähnliches Material aufweist.

14. Elektronisches Bauelement mit einer dampfabweisenden Schutzschicht auf einem Anteil seiner Oberfläche zum Schutz vor Überhitzung beim Dampfphasenlöten nach einem Verfahren nach einem der Ansprüche 1 bis 13.

15. Verwendung eines elektronischen Bauelements nach Anspruch 14 für ein Verfahren nach einem der Ansprüche 1 bis 13
